(19) Europäisches Patentamt
European Patent Office
Office européen des brevets

(11) EP 2 907 164 B1

(12) **EUROPEAN PATENT SPECIFICATION**

(45) Date of publication and mention of the grant of the patent:
**27.12.2017 Bulletin 2017/52**

(21) Application number: **12886806.4**

(22) Date of filing: **15.10.2012**

(51) Int Cl.:
***H01L 31/0224*** *(2006.01)* ***H01L 31/042*** *(2014.01)*
***H01L 31/04*** *(2014.01)* ***H01B 1/22*** *(2006.01)*

(86) International application number:
**PCT/CN2012/082959**

(87) International publication number:
**WO 2014/059577 (24.04.2014 Gazette 2014/17)**

(54) **CONDUCTIVE COMPOSITION**

LEITFÄHIGE ZUSAMMENSETZUNG

COMPOSITION CONDUCTRICE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**19.08.2015 Bulletin 2015/34**

(73) Proprietor: **Dow Global Technologies LLC**
**Midland, MI 48674 (US)**

(72) Inventors:
- **ZHANG, Yong W**
  **Shanghai 200120 (CN)**
- **WANG, William Z**
  **Shanghai 200120 (CN)**
- **SHI, Susan**
  **Shanghai 20081 (CN)**
- **FOLKENROTH, Jason J**
  **Midland, Michigan 48640 (US)**

(74) Representative: **f & e patent**
**Fleischer, Engels & Partner mbB, Patentanwälte**
**Braunsberger Feld 29**
**51429 Bergisch Gladbach (DE)**

(56) References cited:
**WO-A1-2010/056826**
**WO-A1-2012/083172**
**WO-A1-2012/135551**
**US-A1- 2008 302 411**
**US-A1- 2010 186 823**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 907 164 B1

Printed by Jouve, 75001 PARIS (FR)

**Description**

FIELD

The present invention relates to a conductive composition useful for the preparation of electrically conductive structures on a substrate, particularly for the fabrication of electrodes of a semiconductor solar cell.

BACKGROUND

Conductive compositions such as metal-based inks and pastes find wide spread use in the preparation of electrically conductive structures on dielectric or semiconductor substrates for instance in surface mounting technology and the fabrication of hybrid integrated circuits, printed circuit boards, electrooptical, electrochemical, electromechanical or electroceramic devices such as photodiodes, sensors, fuel cells and photovoltaic cells. They are thus a key enabling component in important technological fields, e.g. in sustainable energy technologies, which represent a rapidly growing market driven by an increasing economical pressure related to the depletion of fossil fuels and environmental issues such as the green-house effect. The photovoltaic technology, being dominated by silicon solar cell technology due to efficient mass production, is among the renewable energy technologies with the highest development potential because of the global availability and abundance of solar energy.

The conversion of solar energy to electric energy by a silicon solar cell is based on the generation of electron-hole pairs by the absorption of incident sunlight and the separation of these electrons and holes by the internal electrical field at a p-n junction. As described e.g. by US 2010/0186823 A1 and US 2011/0014743 a silicon solar cell is conventionally made from a p-type silicon wafer by forming an n-type impurity layer on the light receiving surface for instance by thermally diffusing phosphorus from a precursor such as $POCl_3$. Texturizing the wafer surface and an antireflective coating help to reduce light reflection losses. However, the cell conversion efficiency depends not only on the doping profile of the wafer and the surface optical characteristics, but also on the properties of the front and back electrodes that are applied for collection of the photo current usually by screen printing of conductive metal pastes, drying and sintering. Typically a grid of wire electrodes is prepared from a conductive silver paste on top of the light receiving face of the wafer, while on the opposite side of the wafer a back surface field (BSF) electrode is prepared from a conductive aluminum paste. Because soldering to an A1 electrode is not possible, busbar electrodes for interconnecting a plurality of cells to form a photovoltaic module e.g. by soldered copper wires may further be prepared from conductive silver or silver-aluminum pastes over portions of the back side of the wafer.

The conductive pastes used to prepare said electrodes typically comprise three phases, a metal powder that forms a conductive phase, a glass frit and a vehicle, which is commonly a solution of an organic polymer in an organic solvent. The glass frit melts upon sintering and thus provides a persistent good ohmic contact between the conductive phase and the substrate. The vehicle is the key component to control the rheological properties and processability of the composition. It further has to provide adequate wetting and binding properties with respect to the substrate as well as to the metal and glass powders to form a stable dispersion, has to provide a good adhesion to the substrate in the wet and dried state, and should moreover possess a high drying rate and favorable firing characteristics.

Cellulose derivatives, in particular ethyl cellulose, are acknowledged for their excellent dispersing ability, thickening and shape setting effect, and complete decomposition to volatile products upon sintering and are thus widely used as polymer component of the vehicle. However, the adhesion to silicon substrates imparted by such cellulose derivatives is insufficient in view of the increasing demands to silicon solar cells as delamination, even only locally, may seriously impair the overall cell performance due to imperfect electrode formation. In detail e.g. an insufficient effective current collector coverage, locally high contact resistance and/or impeded formation of an Al-Si-alloy $p^+$ layer that causes an internal electrical field preventing a recombination of electrons and holes helping to increase the cell conversion efficiency by sintering of the A1 backside electrode may thus result.

US 2008/0302411 A1 mentions for instance the problem of insufficient adhesion of an A1 backside electrode to a silicon substrate after sintering upon use of conventional A1 paste compositions. It proposes to use a paste composition that comprises besides A1 powder, a glass frit and an organic vehicle such as ethyl cellulose dissolved in an organic solvent a tackifier to improve the adhesion to the Si substrate and to prevent electrode exfoliation. The tackifier could be any organic material having good adhesive performance such as various organic resins including rosin based resins, phenolic resins, melamine based resins or butyl rubber. Similarly US 2010/0186823 A1 proposes to add an acrylate polymer having a molecular weight of more than 100,000 g/mol as pressure sensitive additive to enhance the adhesion to the substrate and prevent the sintered structures from peeling off. However, an enhancement of adhesion in the sintered state may thus only be achieved for certain sintering conditions that cause an incomplete decomposition of the tackifier or pressure sensitive additive. The addition of the organopolymeric adhesive binders increases the load of organic substances to be decomposed upon sintering for attaining good electrical conduction properties. Organic residuals increase the electrical resistivity of the electrode.

In contrast thereto US 2011/0217809 A1 proposes to use specific inorganic polymers as adhesion promoting binders for the formulation of a glass frit free aluminium ink for noncontact printing of the back electrode of a silicon solar cell. The inorganic polymer is polyphenylsilsesquioxane (PPSQ) or poly(hydromethylsiloxane) (PHMS) that can be dissolved in an organic solvent to assist in dispersing the A1 powder and decomposes substantially without leaving behind organic residues upon sintering. These inorganic polymers are claimed to be a beneficial replacement to a glass frit as they decompose to silica upon sintering thereby binding the aluminum particles to the substrate and also lowering the thermal expansion mismatch between the metallic phase and the silicon substrate reducing wafer bow. However, the sintering merely induces a decomposition of the inorganic polymer, but involves no melting since no glass frit is present and the formed silica softens at significantly higher temperature than the applied ~750°C. Thus a less intimate contact between the metal particles and the substrate is formed and the ohmic contact resistance is significantly higher than for a composition with a glass frit that fuses the metal phase to the substrate upon sintering. Accordingly the present invention rather seeks to use the advantages of employing an organopolysiloxane resin binder in the vehicle of a conductive composition that comprises a glass frit.

Conventionally organopolysiloxanes are used in the formulation of conductive compositions as antifoaming or flatting agents as evidenced e.g. by CN 101555394 A and CN 101710497 A, respectively. However, the employed silicone agents are liquid organopolysiloxane oils, which are not functioning as a binder and have a thinning effect degrading the rheological and shape setting properties of the conductive composition, which interferes with the processability in particular in terms of screen printability. Generally, it would be desirable from a perspective of the processing properties to enhance the thixotropic properties of the conductive composition.

The above-discussed prior art concepts to improve the adhesion of a conductive composition to a silicon substrate each rely on the incorporation of a specific polymeric binder, be it organic or inorganic, in addition to a conventional binder such as a cellulose derivative. However, these binders are generally only poorly or moderately compatible with each other and thus tend to separate into distinct phases upon drying, which may cause nonuniform adhesion. Furthermore conventional conductive compositions tend to exhibit defects in the form of bubbles due to gas uptake upon preparation and/or coarse particulates due to agglomeration, which also degrades the uniformity and conduction properties of the resulting electrodes conflicting with the persisting demand to maximize the conversion efficiency of a solar cell, which makes more uniform coatings desirable.

Conventional conductive compositions may further exhibit deficiencies in terms of crack formation and/or significant cell warping due to the development of stress upon sintering, which increase the probability of conduction pathway or wafer breakage raising the portion of defective cells to be discarded. Efforts to reduce cell warping conventionally focus on adjusting the composition of the glass phase basically seeking to approximate its thermal expansion coefficient to the one of the silicon substrate as evidenced e.g. by US 2009/0120490 A1. However, alternative strategies are desirable as altering the glass phase commonly imposes further changes e.g. to the sintering conditions.

In view of the foregoing the present invention aims to provide a conductive composition, which overcomes at least a part of the above-mentioned deficiencies of the prior art. In particular it is an objective of the present invention to provide a stable conductive composition with good processability, such as a paste with enhanced thixotropic properties, that provides improved adhesion to a dielectric or semiconductor substrate such as a silicon substrate and allows to prepare thereon uniform well adherent electrically conductive structures essentially free from defects in the form of cracks, bubbles or coarse particulates, preferably of low ohmic resistance, while inducing less warping of the substrate. The scope of the invention also includes providing an efficient and cost-saving method for the preparation of electrically conductive structures from such conductive composition on a substrate, particularly for the manufacture of a semiconductor solar cell with improved cell efficiency.

Further features and advantages of the invention will be explained in detail below.

## SUMMARY

In a first aspect, the present invention thus relates to a conductive composition comprising

a. a plurality of metal particles,
b. a plurality of glass particles,
c. a vehicle comprising at least one cellulose derivative and at least one solid organopolysiloxane resin dissolved in a mutual organic solvent,

wherein the at least one solid organopolysiloxane resin has a composition of the formula

$$[R^1R^2R^3SiO_{0.5}]_a\ [R^4R^5SiO]_b\ [R^6SiO_{1.5}]_c\ [SiO_2]_d$$

wherein the substituents $R^1$, $R^2$, $R^3$, $R^4$, $R^5$ and $R^6$ each independently represent a hydrocarbon group or a functional

group selected from a hydroxyl, an acyloxy group or an alkoxy group,
and may be the same or different from each other with respect to each individual silicon atom, and

$$0 \leq a \leq 0.4,$$

$$0.01 \leq b \leq 0.99,$$

$$0.01 \leq c \leq 0.99,$$

$$0 \leq d \leq 0.3,$$

under the proviso that at least one hydrocarbon group and at least one functional group are present and a+b+c+d = 1, preferably (b+c) being in a range of 0.7 to 1.

In another aspect of the present invention there is provided a method for preparing one or more electrically conductive structures on a substrate comprising

a. Applying a conductive composition according to the present invention to at least a part of a surface of the substrate,
b. Drying the applied conductive composition at least partially, and then
c. Sintering at a temperature above 600°C.

Furthermore, the invention includes a semiconductor solar cell comprising one or more electrodes prepared from the conductive composition according to the present invention.

The present invention is based on the finding that the use of a vehicle comprising a solid organopolysiloxane resin dissolved in a mutual organic solvent with a cellulose derivative enhances the adhesion of the conductive composition to a substrate, in particular a silicon substrate. The solid organopolysiloxane resin not only acts as adhesion promoter, but also assists in stably dispersing metal and glass particles to avoid an agglomeration of such particles without degrading the rheological properties. From conductive compositions comprising such vehicle uniform electrically conductive structures essentially free from defects in the form of cracks, bubbles or coarse particulates can be prepared on dielectric or semiconductor substrates in an efficient and cost-saving manner e.g. by screen printing, drying and sintering while inducing only low warping of the substrate. Without the intention to be bound to any particular theory the inventors are of the opinion that the siloxane moieties of the organopolysiloxane resin enable a potent interaction with the chemically related omnipresent silica layer on top of a silicon substrate enhancing adhesion in the wet and dried state. Organopolysiloxanes of specific structures as described in detail below are particularly useful as they have surprisingly been found to be highly miscible with cellulose derivatives such as ethyl cellulose. Thus these organopolysiloxanes not only provide strong dispersing ability like cellulose derivatives for metal and glass particles improving the stability of the dispersion, but moreover coatings of excellent uniformity and free of defects can be obtained from the corresponding conductive compositions due to the excellent compatibility of the binders of the vehicle aiding in the fabrication of well adherent electrodes with low contact resistance. Upon sintering under conventional conditions the organic moieties of the solid organopolysiloxane resin decompose completely while the siloxane backbone is converted to silica, which contributes to lower the mismatch of thermal expansion coefficients and thereby reducing thermo mechanical stress between substrate and coating and the resulting warping effect. The silica residues may further contribute to enhance the adhesion between the substrate and the metal phase in the sintered state, especially since the silica may be dissolved in a molten glass phase due to the presence of the glass particles that melt upon sintering. Due to the presence of the glass phase a persistent intimate contact between the metal particles and the substrate is formed providing a good ohmic contact. The foregoing properties render the conductive composition of the present invention very useful for the preparation of electrically conductive structures on dielectric or semiconductor substrates for instance in the fabrication of hybrid integrated circuits or devices such as sensors, fuel cells and photovoltaic cells. In particular, it can be used favorably for manufacturing silicon solar cells with improved cell conversion efficiency.

## BRIEF DESCRIPTION OF DRAWINGS

Fig. 1 shows a TEM image of a film of a 70/30 (wt/wt) blend of ethyl cellulose (ETHOCEL STD 100) and DC 249 flake resin from Dow Corning as an organopolysiloxane resin of formula (II) after $RuO_4$ staining.

DETAILED DESCRIPTION

As explained above the composition of the vehicle is a key aspect of the present invention. The vehicle comprises at least one cellulose derivative. Herein the term cellulose derivative refers to any compound that has a cellulose backbone, i.e. a structure of D-glucopyranose units connected by β-1,4-glycosidic bonding, which has been chemically modified by the introduction of pendant moieties not comprised in pure cellulose. In a preferred embodiment the pendant moieties not comprised in pure cellulose are introduced by etherification and/or esterification of at least a part of the hydroxyl groups at the 2-, 3- and/or 6-position of the glucopyranose repeating units. Correspondingly, the at least one cellulose derivative used according to the invention can comprise 1,4-β-glycosidically linked repeating units represented by formula (I)

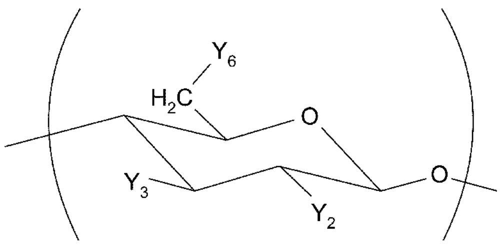

(I)

wherein $Y_2$, $Y_3$ and $Y_6$ each independently are selected from a hydroxyl group, -*OR', -*OC(O)R' and -*OM, wherein -*O designates an oxygen atom directly bound to a carbon atom at the 2-, 3- or 6-position of the repeating units, R' is an univalent organic group and M represents a moiety derived from an inorganic oxyacid by formal abstraction of an OH group, and may be the same or different from each other among the repeating units, under the proviso that at least a part of the carbon atoms at the 2-, 3- and/or 6-position of the repeating units have a substituent $Y_2$, $Y_3$ or $Y_6$ different from a hydroxyl group.

The univalent organic group R' can for instance be selected from an alkyl, cycloalkyl, aryl or aralkyl group, which may each be substituted or, preferably, not substituted. If substituted, the alkyl, cycloalkyl, aryl or aralkyl group may contain one or more functional groups each independently selected e.g. from hydroxyl, ether, thiol, thioether, amine, ester, amide, cyano, isocyanate, thioisocyanate, carbamate, epoxy and halogen. Preferably the univalent organic group comprises 1 to 20, more preferably 1 to 12 carbon atoms. Suitable cycloalkyl groups are e.g. a cyclopentyl, cyclohexyl or methylcyclohexyl group. Suitable aryl and aralkyl groups can be exemplified by a phenyl, biphenyl, naphthyl, tolyl, benzyl, xylyl, cumyl, mesityl or ethylphenyl group. Eligible alkyl groups can be linear or branched, preferably comprising 1 to 8 carbon atoms or most preferably 1 to 4 carbon atoms. Examples include methyl, ethyl, propyl, butyl, pentyl, hexyl, octyl, hydroxyethyl, hydroxypropyl and the like. Linear acyclic alkyl groups are preferable, in particular linear $C_{1-4}$ alkyl groups such as methyl, ethyl, propyl and butyl.

The group -*OM, which can be introduced by esterification with one or more inorganic oxyacids may e.g. be a nitrate group, a sulfate group or a phosphate group.

The cellulose derivative used in the invention may contain a single type of substituent other than OH at the 2-, 3- or 6-position of the repeating units, or more than one type, i.e. mixed substitution. In a preferred embodiment $Y_2$, $Y_3$ and $Y_6$ of the cellulose derivative of formula (I) are each independently selected from a) a hydroxyl group and b) either -*OR' or -*OC(O)R' or -*OM, and may be the same or different from each other among the repeating units. Accordingly, non-limiting examples of suitable cellulose derivatives include cellulose ester materials such as triacetyl cellulose (TAC), diacetyl cellulose (DAC), cellulose acetate propionate (CAP), cellulose acetate butyrate (CAB) or cellulose nitrate and cellulose ether materials such as methyl cellulose, ethyl cellulose, hydroxyl ethyl cellulose, hydroxyl propyl cellulose, cyano ethyl cellulose, methyl ethyl cellulose, ethyl propyl cellulose or ethyl hydroxyl ethyl cellulose as well as mixed ether-ester cellulose materials such as methyl acetyl cellulose, ethyl acetyl cellulose or ethyl propionyl cellulose.

In a preferred embodiment of the present invention the at least one cellulose derivative is a cellulose ether. The cellulose ether can for instance be a cellulose derivative comprising one or more types of alkoxy groups -*OR' having 1 to 4 carbon atoms, for instance methyl cellulose, ethyl cellulose, propyl cellulose, hydroxyl ethyl cellulose or methyl ethyl cellulose. It is particularly preferred that the at least one cellulose derivative is ethyl cellulose.

The average number of hydroxyl groups per repeating units which are in total replaced by -*OR', -*OC(O)R' and -*OM groups at the 2-, 3- and 6-position of the glucopyranose units versus the cellulose parent compound is designated as the degree of substitution (DS). In case all hydroxyl groups are replaced, the degree of substitution would for instance be 3.0. The cellulose derivative used according to the present invention can have a degree of substitution in the range from 0.1 to 2.99, preferably from 1.0 to 2.9, more preferably from 2.0 to 2.8, most preferably from 2.2 to 2.6. The degree of substitution may for instance be determined by $^{1}H$-NMR and $^{13}C$-NMR adapting the methods described in Cellulose Communication 6 (1999), 73-79 and Chirality 12 (9) (2000), 670-674. In the particular case of ethyl cellulose

the degree of substitution may be quantified in accordance with United States Pharmacopeia (USP) XXXII - National formulary (NF) XXVII monograph "ethyl cellulose", section "assay" by reaction with an excess of hydroiodic acid, extraction and quantifiable detection of the liberated ethyl iodide by gas chromatography combined with flame ionization.

The weight average molecular weight ($M_w$) of the cellulose derivative used according to the present invention can be in a range from 1,000 to 1,000,000 g/mol, preferably from 20,000 to 500,000 g/mol, more preferably from 50,000 to 300,000 g/mol. In a particular embodiment the polydispersity index (PD), i.e. the ratio of $M_w$ to the number average molecular weight ($M_n$), is less than 5.0 and more preferable in the range from 2.5 to 4.0. The molecular weight distribution from which $M_n$ and $M_w$ may be determined can be measured experimentally by gel permeation chromatography (GPC) using polystyrene standards e.g. as described in the examples.

Cellulose derivatives useful in the present invention can be prepared according to publicly known methods as described e.g. in "Comprehensive cellulose chemistry", vol.2, Wiley-VCH, 2001 or Ullmanns Encyklopädie der Technischen Chemie, Verlag Chemie, 4th ed., vol.9, pp.192-212 (etherification) and pp.227-246 (esterification) or vol.17, pp.343-354 (nitric acid esterification) from a suitable cellulose raw material such as cotton linter, wood pulp, or a mixture thereof. Numerous commercially available cellulose derivatives exist that can readily be used according to the present invention, e.g. CELLOSIZE hydroxyethyl cellulose materials and methyl cellulose and ethyl cellulose materials sold under the tradenames METHOCEL and ETHOCEL, respectively, all available from The Dow Chemical Company, or Walsroder nitro cellulose marketed by Dow Wolff Cellulosics GmbH.

The conductive composition of the present invention typically comprises the at least one cellulose derivative in an amount of 0.1 to 5 wt.%, preferably 0.3 to 4 wt.%, more preferably 0.5 to 2 wt.% based on the total weight of the composition.

In addition to the at least one cellulose derivative the vehicle of the conductive composition according to the present invention comprises at least one solid organopolysiloxane resin dissolved in a mutual organic solvent with the cellulose derivative. Unless explicitly stated differently, the specified physical state of a material herein refers to the physical state under ambient conditions, i.e. at 23°C and a pressure of 1 atm. The solid nature of the organopolysiloxane resin helps to adjust adequate rheological properties and processability of the conductive composition without the need to incorporate additional amounts of processing aids such as a thickener. The at least one solid organopolysiloxane resin typically has a branched molecular structure, preferably a three-dimensional cross-linked network structure. Typically it has a residual $SiO_2$ content in the range from 40 to 70 wt.%, preferably from 45 to 65 wt.% based on the total weight of the organopolysiloxane resin as determinable e.g. by complete thermal decomposition at 900°C in air. In a preferred embodiment of the present invention the organic moieties of the organopolysiloxane are hydrocarbon groups.

Preferably, the at least one organopolysiloxane used according to the present invention has a weight average molecular weight as measured by GPC using polystyrene standards according to the same procedure as set forth for the cellulose derivative in a range from 500, preferably from 1,000, more preferably from 1,500, to 300,000, or preferably to 100,000, or more preferably to 30,000, or even more preferably to 10,000, or most preferably to 5,000 g/mol. The polydispersity can be in a range from 1 to 5, more preferably from 1.5 to 3.

The solid organopolysiloxane resin can be hydroxy-functional. In a preferred embodiment it comprises silicon-bound hydroxyl groups in an amount of 0.1 to 15 wt.%, preferably 0.5 to 10 wt.%, more preferably 1 to 8 wt.%, even more preferably 3 to 7 wt.%, based on the total weight of the organopolysiloxane resin. The content of hydroxyl groups may be determined by methods well known in the art, e.g. by titration following the procedure described in G.B. Shah, eXPRESS Polymer Letters 2(11) (2008), pp. 830-831.

In a preferred embodiment of the present invention the at least one solid organopolysiloxane resin comprised in the vehicle of the conductive composition yields a miscible blend with the at least one cellulose derivative. According to the present invention the at least one solid organopolysiloxane resin has a composition of the formula (II)

$$[R^1R^2R^3SiO_{0.5}]_a\ [R^4R^5SiO]_b\ [R^6SiO_{1.5}]_c\ [SiO_2]_d \qquad (II)$$

wherein the substituents $R^1$, $R^2$, $R^3$, $R^4$, $R^5$ and $R^6$ each independently represent a hydrocarbon group or a functional group selected from a hydroxyl, an acyloxy group or an alkoxy group, and may be the same or different from each other with respect to each individual silicon atom, and

$0 \leq a \leq 0.4$; a being preferably in a range from 0 to 0.25, more preferably from 0 to 0.1, most preferably from 0 to 0.05,
$0.01 \leq b \leq 0.99$; b being preferably in a range from 0.1 to 0.95, more preferably from 0.3 to 0.9, even more preferably from 0.45 to 0.8,
$0.01 \leq c \leq 0.99$; c being preferably in a range from 0.05 to 0.95, more preferably from 0.1 to 0.75, even more preferably from 0.2 to 0.55, and
$0 \leq d \leq 0.3$; d being preferably in a range from 0 to 0.15, more preferably from 0 to 0.05, even more preferably from 0 to 0.01,

under the proviso that at least one hydrocarbon group and at least one functional group are present and a+b+c+d = 1. It has surprisingly been found that such organopolysiloxane resins can yield highly miscible blends with cellulose derivatives. In the context of the present invention the term "(highly) miscible" does not necessarily require the blend to be single phase on a molecular level or to fulfill the thermodynamic criterion of miscibility, i.e. to have a negative Gibbs free energy of mixing, although the blend may actually have these properties. However, within this invention "(highly) miscible" can also mean that the blend exhibits a single glass transition temperature as measured in accordance with ISO 11357-2 by differential scanning calorimetry (DSC) and/or that discontinuous phase structures potentially present in the blend have a length in the longest dimension of 200 nm or less, preferably 100 nm or less, or more preferably 50 nm or less. The dimensions of discontinuous phase structures can be determined by transmission electron microscopy (TEM) by means known in the art. Fig. 1 exemplarily shows a TEM image of a film of a blend of ethyl cellulose and an organopolysiloxane resin of formula (II).

The organopolysiloxane according to formula (II) preferably comprises predominantly mono- and disubstituted structural monomer units. Thus (b+c) can for instance be in a range from 0.7 to 1, preferably 0.8 to 1, or more preferably 0.9 to 1, or most preferably 0.95 to 1. The molar ratio of mono- to disubstituted structural monomer units, i.e. c/b, can moreover be in a range from 5:1 to 1:5, preferably from 3:1 to 1:3, more preferably from 2:1 to 1:2. The molar fractions of the unsubstituted, mono-, di- and trifold substituted structural monomer units constituting the organopolysiloxane (d, c, b and a) can be determined quantitatively by $^{29}$Si-NMR spectroscopy as described in the examples.

The at least one hydrocarbon group of the organopolysiloxane of formula (II) can have 1 to 30 carbon atoms comprising one or more aliphatic and/or aromatic moieties, wherein the aliphatic moieties can be linear or branched, saturated or unsaturated. The at least one hydrocarbon group can for instance be selected from an alkyl, cycloalkyl, aryl or aralkyl group having 1 to 12 carbon atoms such as a methyl, ethyl, propyl, butyl, amyl, hexyl, octyl, dodecyl, cyclohexyl, methylcyclohexyl, phenyl, biphenyl, naphthyl, tolyl, benzyl, xylyl, and ethylphenyl group, or a mixture of any of the foregoing. In a preferred embodiment it is selected from an alkyl group having 1 to 4 carbon atoms and/or phenyl. In one especially preferable embodiment $C_1$-$C_4$ alkyl groups such as methyl groups and phenyl groups are both present in the polysiloxane. If alkyl and phenyl substituents are both present, the molar ratio of alkyl to phenyl substiutuents, which can be determined by $^1$H-NMR spectroscopy, preferably ranges from 1:15 to 15:1, or preferably from 1:10 to 10:1, or more preferably from 1:7 to 7:1.

Besides the at least one hydrocarbon group the organopolysiloxane of formula (II) comprises at least one Si-bound functional group selected from a hydroxyl, an acyloxy or an alkoxy group. Herein acyloxy and alkoxy groups typically comprise 1 to 4 carbon atoms such as a formyl, acetyl, propionyl, butyryl, methoxy, ethoxy, propoxy or butoxy group. The organopolysiloxane may comprise two or more different functional groups or a single type of functional group. In the latter case the functional groups of the organopolysiloxane of formula (II) are typically hydroxyl groups, preferably present in an amount as specified above.

The organopolysiloxanes described in the foregoing can be produced by hydrolytic polycondensation according to methods well known in the art as described e.g. in Ullmanns Encyklopädie der technischen Chemie, Verlag Chemie, 4th ed., vol. 21, pp.511-541 from precursors of the formula $SiX_qR_{4-q}$, wherein X represents a hydrolysable substituent such as a halogen, R represents a non-hydrolysable substituent, which can each individually be selected from a hydrocarbon group as specified above and q is an integer in the range of 1 to 4. Commercially available organopolysiloxanes that can favorably be employed according to the present invention include for instance 217, 220, 233, 249 and 255 Flake Resin or Z-6018 and 3074 Resin intermediates distributed by Dow Corning Corp., Silres® 603 or 605 available from Wacker Chemie AG.

The above-mentioned solid organopolysiloxane resins have been found to effectively enhance the adhesion of the conductive composition and electrically conductive structures derived therefrom to a substrate such as a silicon substrate. Furthermore they assist in stably dispersing metal and glass particles to avoid an agglomeration of such particles without degrading the rheological properties. Organopolysiloxane resins, which form highly miscible blends with cellulose derivatives such as organopolysiloxanes of formula (II) are particularly suitable for the use in conductive compositions according to the present invention since such compositions are stable versus phase separation and may provide well adherent coatings of excellent uniformity due to the compatibility of the binders of the vehicle.

The at least one solid organopolysiloxane resin is typically comprised in the conductive composition of the present invention in an amount of 0.1 to 5 wt.%, preferably 0.3 to 3 wt.%, more preferably 0.5 to 2 wt.% based on the total weight of the composition.

The vehicle further comprises a mutual organic solvent wherein the at least one solid organopolysiloxane resin and the at least one cellulose derivative set forth above are dissolved. In principle the organic solvent can be any organic solvent or solvent mixture, wherein the at least one cellulose derivative and the at least one organopolysiloxane set forth above are both soluble, i.e. wherein they exhibit a solubility at 23°C of at least 10 g/L, preferably at least 25 g/L, or more preferably at least 50 g/L each. Preferentially the organic solvent is an organic solvent having a boiling point in the range from 70 to 250°C at 1 atm. The organic solvent can e.g. be selected from hydrocarbons such as naphtha, hexane, cyclohexane, cyclohexene, benzene, toluene, kerosene, natural or mineral oils, terpene-based solvents such as terpineol,

myrcene, limonene, pinene, or ocimene, whereof terpineol is preferable, halogenated hydrocarbons such as dichloroethane and dichlorobenzene, and hydrocarbons with one or more other functional groups e.g. selected from an ether, keto, aldehyde, ester and and/or hydroxyl group, for instance cyclohexanone, methyl ethyl ketone, butyl aldehyde, benzaldehyde, cyclohexyl acetate, ethanol, butyl alcohol, cyclohexanol, furfuryl alcohol, Texanol, propylene phenoxetol, benzylalcohol, 1,4-dioxane, tetrahydrofuran, phenyl ether, benzyl ether, glycol ethers such as and glycol ether esters, and mixtures of any of the foregoing. Eligible glycol ethers are e.g. ethylene glycol monomethyl ether, ethylene glycol monoethyl ether, ethylene glycol monopropyl ether, ethylene glycol monobutyl ether, diethylene glycol monomethyl ether, diethylene glycol monoethyl ether, diethylene glycol monobutyl ether, ethylene glycol diethyl ether, diethylene glycol diethyl ether, dipropylene glycol monomethyl ether, propylene glycol monobutyl ether, propylene glycol phenyl ether, propylene glycol monomethyl ether and dipropylene glycol monobutyl ether. Suitable glycol ether esters comprise e.g. ethylene glycol methyl ether acetate, ethylene glycol monoethyl ether acetate and ethylene glycol monobutyl ether acetate. In a preferred embodiment of the present invention the organic solvent is selected from terpineol, butyl carbitol, ethylene glycol monobutyl ether acetate, propylene phenoxetol, Texanol or a mixture of any of the foregoing.

The conductive composition typically comprises the organic solvent in an amount of 15 to 30 wt.%, preferably 20 to 27 wt.% based on the total weight of the composition.

The conductivity of the conductive composition of the present invention, which may e.g. have a specific conductivity of at least 0.01 S/cm, is imparted by the metal particles comprised therein, which form a conductive phase and can be made of any conductive metal, alloy or a mixture thereof. For instance the metal particles can be selected from particles made of aluminum, silver, copper, nickel, platinum, palladium, gold or alloys of any of the foregoing, or mixtures thereof. In a preferred embodiment of the present invention aluminum particles and/or silver particles are used. The metal particles can have an average particle size in the range from 10 nm to 20 $\mu$m, more preferable from 50 nm to 15 $\mu$m, even more preferable from 0.2 to 10 $\mu$m. The shape of the metal particles is not particularly limited and can e.g. be spherical, granular, needle-like, pillar-like, platelet-like, sponge-like, polygonal, irregular, or any combination thereof. Commercially available metal powders such as KY456 A1 powder from Jin Yuan Powder Materials Co. Ltd. or 7000-07 Ag powder from Ferro Corp. can be employed as the metal particles component of the conductive composition of the present invention. The metal powder can be selected according to the targeted application of the conductive composition of the present invention such as e.g. an aluminum powder for a conductive composition for the preparation of the BSF electrode of a silicon solar cell or a silver powder for the formulation of a conductive composition intended for the preparation of front electrodes of a silicon solar cell. The metal particles are usually employed in an amount of 60 to 90 wt.%, preferably more than 70 wt.% to 85 wt.% based on the total weight of the conductive composition.

The glass particles present in the conductive composition of the present invention function as inorganic binder for the formation of an intimate and persistent contact between the conductive phase and a substrate by melting and re-solidification in the sintering process. Any glass frit known to those skilled in the art as suitable for the formulation of conductive compositions can be used. The glass particles can e.g. comprise oxides selected from $SiO_2$, $B_2O_3$, $Al_2O_3$, $Bi_2O_3$, MgO, $Sb_2O_3$, PbO, CaO, BaO, ZnO, $Na_2O$, $Li_2O$, $K_2O$, $ZrO_2$, $TiO_2$, $IrO_2$, $SnO_2$ and combinations thereof. In one embodiment of the present invention the glass particles are made of a lead-free glass, whereas in another embodiment they are made of a lead-containing glass. The average particle size of the glass particles is typically below 20 $\mu$m such as in a range from 0.1 to 15 $\mu$m, or preferably from 0.5 to 10 $\mu$m. The person skilled in the art understands that the glass component has to be selected according to the targeted application of the conductive composition providing a good adhesion to the respective selected substrate and metal particles, a thermal expansion coefficient similar to the substrate and a softening temperature well below the maximum sintering temperature. For instance the glass particles may have a softening temperature in the range from 300 to 650°C. In case of a silicon substrate the thermal expansion coefficient of the glass may e.g. be in a range from $10x10^{-7}$ to $100x10^{-7}$/°C. The preparation of such glass frits is well-known and involves melting together the constituent oxides, quenching the resulting homogeneous glass melt and milling of the solidified glass e.g. in a ball mill to obtain the desired particle size. Suitable glass frits are commercially available e.g. from Asahi, Ferro Corp. or XuanYan Glass Materials Co Ltd. The glass particles are typically comprised in an amount of 0.5 to 5 wt.%, preferably 1 to 3 wt.%, more preferably 1.5 to 2.5 wt.% in the conductive composition according to the present invention.

With respect to the above-mentioned dimensions of metal and glass particles it is noted that unless specified differently the size of a particle is defined in terms of the diameter of the smallest possible circle that encloses the respective particle completely and touches its outer contours in a two-dimensional electron microscopic image in the context of the present invention. Determination of the respective average particle size relies on determining the particle size of at least 500 individual particles of the respective type and calculating the number averaged particle size.

Optionally the conductive composition of the present invention may further comprise one or more additional polymeric binders and/or one or more additives conventionally used in the formulation of conductive compositions being different from the metal particles, glass particles, cellulose derivative, solid organopolysiloxane resin and organic solvent. As additional polymeric binder for instance an acrylic resin, polyurethane, phenol formaldehyde resin, polyvinyl butyral, polyvinyl alcohol, polyester, epoxy resin, polyimide, alkyd resin or the like organic polymer can be employed. The

additional polymeric binder may be comprised in the conductive composition in an amount of 0 to 3 wt.% based on the total weight of the composition. The at least one additive optionally present can e.g. be selected from a plasticizer, a surfactant, a coupling agent, a defoaming agent, a leveling agent, a dispersing agent, a conductive agent and a thixotropic agent. The total amount of such additives in the conductive composition is typically in the range from 0 to 2 wt.% based on the total weight of the composition. In a preferred embodiment of the present invention the conductive composition of the present invention comprises at least one conductive agent, which can be selected e.g. from conductive mineral powder and carbonaceous conductive agents such as carbon black, graphite, glassy carbon and carbon nanotubes or nanoparticles. In a particularly preferred embodiment of the present invention the conductive composition comprises a carbonaceous conductive agent, preferably graphite. This allows to more than compensate any increase of the electrical resistivity that may be caused by silica residuals formed from the organopolysiloxane resin upon sintering even if comprising such conductive agent in a concentration as low as 0.05 wt.% based on the total weight of the composition. The optional conductive agent may e.g. be comprised in an amount of 0.1 wt.% or less based on the total weight of the composition. Moreover it is preferable that the conductive composition comprises at least one thixotropic agent e.g. nanoparticulate silica, precipitated calcium carbonate, a hydrogenated castor oil, an oxidized polyethylene wax, an amide wax or a combination of any of the foregoing. In a particularly preferred embodiment of the present invention the conductive composition comprises at least one amide-functional organic oil or wax, preferably an amide modified hydrogenated castor oil, because it has been found that incorporation of such material can enhance the thixotropic properties significantly more than other thixotropic agents. The optional thixotropic agent can e.g. be comprised in the conductive composition in an amount of 0.2 wt.% or less based on the total weight of the composition.

The conductive composition according to the present invention can be prepared by common means known in the art. Typically the vehicle is prepared in a first step by dissolving the at least one cellulose derivative, the at least one solid organopolysiloxane resin and any additional polymeric binder, if used, in the mutual organic solvent. The formation of a homogeneous solution can be promoted by stirring and heating e.g. to a temperature in the range 25 to 90°C, if required. Subsequently the vehicle is mixed with the metal particles and the glass particles and this mixture is homogenized to form the conductive composition of the present invention. Homogenization can e.g. be carried out in a ball mill or a roll mill such as a three roll grinder. Additives, if any, can be incorporated at any stage of the preparation. Thus additives can e.g. be dissolved or dispersed before, concurrently or after dissolving the binders in the organic solvent upon preparation of the vehicle or added thereafter to the vehicle before, concurrently or after mixing with the metal and glass particles.

The conductive composition of the present invention obtainable this way should have a consistency and rheological properties suitable for the application of defined electrically conductive structures to a substrate, preferably being printable. It may for instance be an ink, a paste or a solid with a melting point below 50°C. In a particularly preferred embodiment of the present invention the conductive composition is a paste. Preferably the conductive composition has a viscosity as measured with a Brookfield RV DV-II+ Pro instrument at a temperature of 23°C using a #51 spindle and a rotational speed of 1 rpm in the range of 5,000 to 200,000 mPa·s, preferably in the range of 10,000 to 100,000 mPa·s, more preferably in the range of 20,000 to 60,000 mPa·s. Furthermore the conductive composition according to the present invention can have a thixotropic index as the ratio of the viscosity $\eta_{0.1}$ measured at a rotational speed of 0.1 rpm to the viscosity $\eta_1$ measured a rotational speed of 1 rpm in the range from 1.5 to 5.0, preferably from 2.0 to 4.0.

The conductive composition of the present invention can be used to prepare one or more electrically conductive structures on a substrate. The substrate may be a dielectric or semiconductor substrate. Non-limiting examples include an alumina, zirconia, titania, boron nitride, glass or silica substrate and a silicon or a group III-V-semiconductor such as GaAs substrate, respectively. In a particularly preferred embodiment the substrate is a silicon substrate. The electrically conductive structures can e.g. be electrical contacts and electrodes, typically of well-defined geometrical shape. They can be prepared in an efficient and cost-saving manner by a method comprising

a. Applying the conductive composition according to the invention to at least a part of a surface of the substrate,
b. Drying the applied conductive composition at least partially, and then
c. Sintering at a temperature above 600°C.

Different conventional techniques can be used to apply the conductive composition to at least a part of the surface of the substrate such as screen printing, pad printing, spin coating, brushing, dipping, micro-jet direct writing or extrusion. Preferably the conductive composition according to the invention is applied by screen printing. It is typically applied in an amount that yields a coating having a thickness of 10 to 50 $\mu$m thickness.

In the drying step at least a part of the organic solvent is evaporated from the applied conductive composition e.g. by direct heating, radiant heating, microwave heating, exposure to a stream of optionally heated gas, by applying a vacuum or any combination thereof. Typically the at least partial drying is carried out by heating the substrate with the conductive composition applied thereto to a temperature in the range of 100 to 300°C for several seconds up to about 15 min, e.g. by means of an infrared (IR) drier.

The sintering serves to burn the organic components of the conductive composition without residues, decompose the siloxane backbone of the organopolysiloxane resin to silica and fuse the glass phase for the formation of an intimate and persistent good ohmic contact between the metallic phase and the substrate. Furthermore a diffusion of the metal into the substrate or a melt-driven alloy formation between the substrate and the metal may occur under these conditions. The sintering is typically conducted by heating the at least partially dried specimen to a temperature in the range from 600 to 1000°C for a period of 1 to 500 seconds e.g. in an IR belt furnace.

The electrically conductive structures prepared from the conductive composition according to the invention can be highly uniform and well adherent to the substrate, and essentially free from defects in the form of cracks, bubbles or coarse particulates, while inducing only low warping of the substrate. These characteristics render the conductive compositions of the present invention highly attractive for a variety of different applications including surface mounting technology and the fabrication of hybrid integrated circuits, printed circuit boards, multi-layer ceramic capacitors, electrooptical, electrochemical, electromechanical and electroceramic devices. The conductive compositions according to the present invention are particularly useful as a replacement of conventional conductive pastes for the preparation of electrodes of semiconductor solar cells.

Thus the present invention is also related to a semiconductor solar cell such as a group III-V type solar cell or, preferably, a silicon solar cell, comprising one or more electrodes prepared from the conductive composition according to the invention. The fabrication of the semiconductor solar cell can follow conventional methods except for using at least one conductive composition according to the present invention for preparation of at least one of the electrodes.

For instance a silicon solar cell can be formed from a wafer of single crystalline, polycrystalline or amorphous p-type silicon typically having a thickness in the range of 100 to 300 μm. In a first step a surface of the wafer is typically texturized by forming a rough surface with μm-sized pyramid-shaped structures to reduce the reflectivity towards incident sunlight. After removal of the native silica layer e.g. by etching with HF an n-type impurity layer having a thickness of typically 0.1 to 0.5 μm may then be prepared on the side of the light receiving surface by doping with an n-type dopant such as phosphorous or another group V element, e.g. by a thermal diffusion treatment using $POCl_3$ as a precursor, forming a p-n junction. The n-type layer may subsequently be locally removed at the edges of the substrate e.g. by etching or by means of a laser to increase the shunt resistance. Eventually an antireflection layer such as a silicon nitride, titania, $MgF_2$ or silica layer, typically having a thickness in the range of 60 to 100 nm, may be deposited on the n-type impurity layer e.g. by plasma chemical vapor deposition to reduce reflective losses. Such pre-formed p-n junction type wafer may then be used as substrate for the preparation of the front and back electrodes e.g. according to the method according to the present invention presented above. Thus a grid of wire electrodes typically having a width of 50 to 200 μm and a thickness in the range of 20 to 40 μm can be applied to the light receiving side of the wafer from a silver-based conductive composition. The grid of wire electrodes should on the one hand cover a surface portion as small as possible to maximize the light receiving area, their minimum area density and dimensions being on the other hand limited by the requirements of an efficient current collection and conduction. The backside of the wafer may be coated, typically in a thickness of 20 to 50 μm, with an aluminum-based conductive composition for the formation of an aluminum back surface field (BSF) electrode. Additionally busbar electrodes having e.g. a width of 1-4 mm can be applied to the backside from a silver and aluminum based conductive composition either on top of the aluminum electrode or prior to the application of the aluminum based conductive composition on the bare substrate, wherein the aluminum based conductive composition is then subsequently applied in the bare areas in between the busbar electrodes with a partial overlap. Herein at least one, preferably all, of the used metal based conductive compositions is a conductive composition according to the present invention. The conductive compositions can be pastes that are preferably applied to the wafer by screen printing. Drying and/or sintering as set forth above can be carried out separately for the single types of electrodes or one or more types of electrodes selected from a) the Ag front electrodes, b) the aluminum backside electrode and c) the backside Al-Ag electrodes can be co-fired. As known to the person skilled in the art the sintering conditions have to be adjusted e.g. to the above indicated range to enable efficient formation of a back surface field electrode by diffusion of A1 into the p-type silicon substrate or dissolution of silicon in molten aluminum followed by epitaxially re-deposition upon cooling forming a $p^+$ layer with a high concentration of aluminum dopant. The $p^+$ layer causes a field effect that prevents the recombination of electrons and holes and thus helps to improve the energy conversion efficiency of the cell. Moreover Ag may penetrate through the antireflective layer upon sintering to electrically contact the n-type impurity layer. Due to the above-discussed enhanced properties of electrodes prepared from conductive compositions according to the present invention semiconductor solar cells with improved cell conversion efficiency are thus feasible.

The present invention will be illustrated in more detail by the following examples, but the invention is not meant to be limited by these. Unless otherwise mentioned, all parts and percentages are by weight. References to standards such as ISO or ASTM standards within this invention relate to the latest version of the corresponding standard publicly available at the effective date of filing, if not specified else.

EXAMPLES

Materials

ETHOCEL STD 10 (EC STD 10): Ethyl cellulose available from The Dow Chemical Company, DS: 2.5, $M_w$: 83,000 g/mol, PD: 3.30

ETHOCEL STD 45 (EC STD 45): Ethyl cellulose available from The Dow Chemical Company, DS: 2.5, $M_w$: 158,000 g/mol, PD: 3.04

ETHOCEL STD 100 (EC STD 100): Ethyl cellulose available from The Dow Chemical Company, DS: 2.5, $M_w$: 214,000 g/mol, PD: 3.42

DC 249: Solid flake hydroxyl-functional organopolysiloxane resin having Si-bound methyl and phenyl groups available from Dow Corning Corp., content of Si-bound OH groups: 5 wt.%, molar ratio Ph/Me: 1.3/1, $M_w$: 2,763 g/mol, structural parameters as determined by $^{29}$Si-NMR: a: 0, b: 0.67, c: 0.33, d: 0

DC 217: Solid flake hydroxyl-functional organopolysiloxane resin having Si-bound methyl and phenyl groups available from Dow Corning Corp., content of Si-bound OH groups: 6 wt.%, molar ratio Ph/Me: 6.6/1, residual $SiO_2$ content: 47 wt.%, $M_w$: 2,000 g/mol, structural parameters as determined by $^{29}$Si-NMR: a: 0, b: 0.57, c: 0.43, d: 0

201 methyl silicone oil: polydimethylsiloxane obtained from Sinopharm Chemical Reagent Co. Ltd., content of Si-bound OH groups: 0 wt.%, residual $SiO_2$ content: 74 wt.%

Butyl carbitol (BC) from The Dow Chemical Company, purity ≥ 99.0 wt.%

Terpineol (TP) from Sinopharm Chemical Reagent Co. Ltd., cp grade

Butyl carbitol acetate (BCA) from The Dow Chemical Company, purity ≥ 99.6 wt.%

A1 powder KY456 from Jin Yuan Powder Materials Co. Ltd.

Glass frit XY18008 from XuanYan Glass Materials Co. Ltd.

Molecular weight determination

The above-mentioned weight average molecular weights and polydispersity indices of the employed ETHOCEL materials and organopolysiloxanes were measured by gel permeation chromatography (GPC) using an Agilent 1200 instrument equipped with an Agilent refractive index detector held at a temperature of 40°C. For each measurement 20 mg of the respective sample material were dissolved in 10 mL of tetrahydrofuran (THF). A 20 μL aliquot of this solution was then injected into the inlet port of the GPC instrument operated with a constant elution rate of 0.3 mL THF per minute utilizing two mini mixed D columns (4.6 x 250 mm) in tandem mode held at 40°C for separation according to molecular weight. The system was calibrated using PL polystyrene narrow standards (part no. 2010-0101) with molecular weights ranging from 580 to 316,500 g/mol.

Determination of structural parameters a, b, c, d of the organopolysiloxane resin

The reported molar fractions of the unsubstituted, mono-, di- and trifold substituted structural monomer units constituting the organopolysiloxane resins used in the examples have been determined quantitatively by $^{29}$Si-NMR spectroscopy. Solid state $^{29}$Si-NMR spectra were acquired at 22°C on a Bruker Avance 400 wide bore instrument with a zirconia sample rotor and a 7 mm MAS probe loaded with the respective finely ground organopolysiloxane resin at a $^{29}$Si resonance frequency of 79.4 MHz using direct polarization/magic angle spinning (MAS) experiments at a spinning frequency of 4 kHz with a 5 μs 90° excitation pulse, a 500 s recycle delay between single scans and 50 kHz TPPM decoupling, averaging over 384 scans. Chemical shifts (Δ) were calibrated with an external standard of tris(trimethylsilyl)silane (TTMSS, Δ = -9.83, -138.36 ppm). Peak assignments to mono-, di-, or trifold substituted or unsubstituted structural monomer units of the organopolysiloxane were made according to chemical shifts characteristic to each respective structure known to the skilled artisan e.g. from G. Engelhardt et al., Journal of Organometallic Chemistry, 54 (1974), 115-122, C. B. Wu et al., High Performance Polymers, 22 (2010), 959-973 and Huang et al., Journal of Applied Polymer Science, 70 (1998), 1753-1757. For the investigated polysiloxanes the following peaks were observed and assigned as indicated: $\delta$ = -17.5 ppm $(Me)_2Si(O_{1/2})_2$, $\delta$ = -56.2 ppm $(HO)(Me)Si(O_{1/2})_2$, $\delta$ = -63.6 ppm $(Me)Si(O_{1/2})_3$, $\delta$ = -68.7 ppm $(HO)(Ph)Si(O_{1/2})_2$ and $\delta$ = -78.8 ppm $(Ph)Si(O_{1/2})_3$ for DC 249; $\delta$ = -60.6 ppm $(Me)Si(O_{1/2})_3$, $\delta$ = -69.1 ppm $(HO)(Ph)Si(O_{1/2})_2$ and $\delta$ = -78.3 ppm $(Ph)Si(O_{1/2})_3$ for DC 217. The molar fractions were then calculated as the ratio of the cumulated integrated area of all peaks related to the respective type of structural monomer unit (a: $[R^1R^2R^3SiO_{0.5}]$, b: $[R^4R^5SiO]$, c: $[R^6SiO_{1.5}]$, d: $[SiO_2]$) to the cumulated total integrated area of all peaks. Peak deconvolution of each $^{29}$Si DP/MAS NMR spectrum was performed using the DMFit curve-fitting program (D. Massiot et al., Magn. Reson. Chem., vol. 40 (2002), 70-76). The peaks were freely fit with mixed Gaussian/Lorentzian character, linewidth and intensity

as deconvolution parameters. Major spinning sidebands resulting from magic-angle spinning at 4 kHz were accounted for in the fitting. If the parameter value a, b, c or d associated with a specific structural monomer unit is reported to be zero, it means that no signal corresponding to the respective structural units could be detected within the $^{29}$Si-NMR analysis, but does not preclude the actual presence of such structural units in an amount below the detection limit.

Blend miscibility

A 90 μm thick blend film was prepared by casting a homogeneous solution obtained by dissolving 10.0 g EC STD 100 and 4.3 g DC 249 in 90 g of a solvent mixture of 84 parts by weight toluene, 5.3 parts by weight acetone and 10.7 parts by weight ethyl acetate on a glass substrate using an Elcometer 4340 automatic film applicator, drying in an oven at 60°C for 2 h and then at 120°C for 2 h and subsequent peeling off the dried film from the substrate. Sections of approximately 60 nm thickness obtained from the central region of the cast film were obtained with a Leica EM UC6 microtome and collected on a 1000 mesh TEM grid. The film sections were stained by exposure to the vapor phase of a 0.5 wt.% aqueous $RuO_4$ solution for 10 minutes and then imaged on a JEOL JEM-1230 transmission electron microscope operated at 100 kV with Gatan-791 and 794 digital cameras. Fig. 1 is a TEM image obtained this way and evidences that EC STD 100 and DC 249 form a very homogeneous nanostructure upon blending. This was confirmed also for blends of other organopolysiloxane resins of formula (II) such as DC 217 with ethyl cellulose materials. If exhibiting distinct features at all upon TEM analysis, they showed features with a length in the longest dimension of less than 200 nm dispersed in a uniform matrix as illustrated exemplarily in Fig. 1. This indicates excellent miscibility of organopolysiloxane resins of formula (II) with cellulose derivatives.

Vehicle preparation and testing

A vehicle according to the invention (Example 1A) was prepared by adding 16 g of ETHOCEL STD 45 and 4 g of DC 217 to 180 g of butyl carbitol under stirring. The stirred mixture was heated to about 70°C and held at this temperature for 3 h for complete dissolution of the solids. The resulting homogeneous solution was then allowed to cool to ambient temperature.

Comparative Examples were prepared as described for Example 1A, but using only ETHOCEL STD 45 as binder (Comp. Ex. 1B) or using as non-cellulosic binder 201 methyl silicone oil (Comp. Ex. 1C), a modified polyester resin (Comp. Ex. 1D) or an epoxy resin (Comp. Ex. 1E) instead of DC 217, respectively, in accordance with Table 1.

For studying their adhesion properties vehicles 1A-1E were each coated with a loading of about 1.0 g by using an AFA-III automatic thick film coater equipped with a stainless steel blade and a drying box on a single crystalline silicon wafer having lateral dimensions of 125 x 125 $mm^2$ and a thickness of 200 μm. The cast films were dried in air at 230°C for 5 min and had a thickness of 15 ± 3 μm. The adhesion of each coating to the wafer was measured according to method B of ASTM D3359 by applying a grid of two groups of eleven parallel cuts intersecting each other at an angle of 90 degrees, subsequent application of a 25 mm wide sticking tape of type P-99 supplied by PERMACEL from the same batch for all measurements over the grid, and visual inspection of the grid area after swift peeling off the tape at an angle of 180 degrees. The results of the adhesion measurement are summarized in Table 1, wherein the scale ranges from 0B (worst adhesion) to 5B (best adhesion). It can be seen that the adhesion of an ethyl cellulose containing vehicle composition to a silicon substrate can be significantly improved by incorporation of a solid organopolysiloxane resin (Ex. 1A vs. Comp. Ex. 1B), whereas the incorporation of a polyester (Comp. Ex. 1D) or epoxy resin (Comp. Ex. 1E) as additional binder to ethyl cellulose degraded the adhesion to the silicon substrate. Addition of a silicone oil (Comp. Ex. 1C) improved the adhesion slightly, but significantly less than the same amount of the solid organopolysiloxane resin of Example 1A. Thus the use of a solid organopolysiloxane resin as an adhesion promoter appears favorable for the formulation of conductive compositions that comprise an ethyl cellulose based vehicle.

Further vehicles according to the present invention were prepared as described for Example 1A with the difference that ETHOCEL STD 45, DC 217 and in each case a distinct thixotropic agent as listed in Table 1 (Examples 2A-2D) or as a reference no thixotropic agent (Example 2E) were dissolved in the amounts specified in Table 1 in the specified amount of a 2:1 (wt/wt) solvent mixture of terpineol and butyl carbitol acetate to investigate the effect of the addition of different thixotropic agents on the rheological properties of the vehicle.

The viscosity of vehicles 2A-2E were measured with a Brookfield RV DV-II+ Pro instrument at a temperature of 23°C using a #51 spindle and a rotational speed of 1 rpm. Moreover the viscosity was each measured with a rotational speed of 10 rpm for calculation of the thixotropic index $\eta_1/\eta_{10}$ as the ratio of the viscosity at 1 rpm to the viscosity at 10 rpm. Furthermore vehicles 2A-2E were tested on an AR 2000ex rheometer from TA Instruments equipped with a Peltier element for temperature control in parallel plate geometry using aluminum plates of 40 mm diameter. About 2 mL of the respective vehicle solution were provided between the plates and equilibrated at the set measurement temperature of 30°C for 2 min. Then the shear rate was first linearly increased from 0.1 to 100 $s^{-1}$ within 10 min and subsequently ramped down again linearly from 100 to 0.1 $s^{-1}$ within 10 min simultaneously measuring the shear stress in dependence

of the shear rate by acquiring a total of 60 data points. From plots of the shear stress versus the shear rate the thixotropic loop was calculated as the integral area between the ramp up and the ramp down measurement. The measured rheological properties are summarized in Table 1 and show that the thixotropic loop and the thixotropic index can be increased substantially more by addition of an amide-functional compound such as Crayvallac MT (Ex. 2A) and Hycasol R12 (Ex. 2B) than by other thixotropic agents such as nanoparticulate silica (Ex. 2C) or hydrogenated castor oil (Ex. 2D) versus the reference of a vehicle without a thixotropic additive (Ex. 2E). The thixotropic loop is for instance increased by a factor of more than 10 in case of Examples 2A-B compared to an increase by a factor below 2 for Examples 2C-D versus Example 2E as a reference. Accordingly, amide-functional organic waxes or oils represent particularly effective thixotropic agents for conductive compositions according to the present invention.

Table 1: Composition, adhesion according to ASTM D3359 and rheological properties of prepared vehicles

| Example | Cellulose derivative, mass (wt.%) | Non-cellulosic binder, mass (wt.%) | Solvent, mass (wt%) | Thixotropic additive, mass (wt.%) | Adhesion | Viscosity [mPa·s] | Thixotropic loop [Pa/s] | $\eta_1/\eta_{10}$ |
|---|---|---|---|---|---|---|---|---|
| **1A** | EC STD 45 16 g (8 %) | DC 217 4 g (2 %) | BC 180 g (90 %) | - | 5B | n/m | n/m | n/m |
| **1B (Comp. Ex.)** | EC STD 45 20 g (10 %) | - | BC 180 g (90 %) | - | 2B | n/m | n/m | n/m |
| **1C (Comp. Ex.)** | EC STD 45 16 g (8 %) | 201 methyl silicone oil 4 g (2 %) | BC 180 g (90 %) | - | 3B | n/m | n/m | n/m |
| **1D (Comp. Ex.)** | EC STD 45 16 g (8 %) | TEGO AddBond LTH[1] 4 g (2 %) | BC 180 g (90 %) | - | 0B | n/m | n/m | n/m |
| **1E (Comp. Ex.)** | EC STD 45 16 g (8 %) | D.E.R. 669E[2] 4 g (2 %) | BC 180 g (90 %) | - | 1B | n/m | n/m | n/m |
| **2A** | EC STD 45 10 g (5 %) | DC 217 10 g (5 %) | TP/BCA 178 g (89 %) | Crayvallac MT[3] 2 g (1 %) | n/m | 3,500 | 1,556 | 3.4 |
| **2B** | EC STD 45 10 g (5 %) | DC 217 10 g (5 %) | TP/BCA 178 g (89 %) | Hycasol R12[4] 2 g (1 %) | n/m | 2,600 | 1,423 | 2.8 |
| **2C** | EC STD 45 10 g (5 %) | DC 217 10 g (5 %) | TP/BCA 178 g (89 %) | Aerosil R812[5] 2 g (1 %) | n/m | 1,300 | 204 | 1.8 |
| **2D** | EC STD 45 10 g (5 %) | DC 217 10 g (5 %) | TP/BCA 178 g (89 %) | Antisettle CVP[6] 2 g (1 %) | n/m | 800 | 153 | 1.1 |

(continued)

| Example | Cellulose derivative, mass (wt.%) | Non-cellulosic binder, mass (wt.%) | Solvent, mass (wt%) | Thixotropic additive, mass (wt.%) | Adhesion | Viscosity [mPa·s] | Thixotropic loop [Pa/s] | $\eta_1/\eta_{10}$ |
|---|---|---|---|---|---|---|---|---|
| **2E** | EC STD 45 10 g (5 %) | DC 217 10 g (5 %) | TP/BCA 180 g (90 %) | - | n/m | 600 | 135 | 1.0 |

[1] solid modified polyester resin from Evonik-Degussa
[2] high molecular weight solid epoxy resin from The Dow Chemical Company
[3] amide modified hydrogenated castor oil from Cray Valley
[4] amide modified hydrogenated castor oil from Olechemical
[5] hydrophobic fumed silica from Evonik-Degussa
[6] hydrogenated castor oil from Cray Valley n/m: not measured

Preparation of conductive aluminum pastes

Different conductive aluminum pastes were prepared according to the formulations illustrated in Tables 2, 3 and 4. In a first step the ethyl cellulose and the organopolysiloxane component DC 217 or 201 methyl silicone oil as well as any soluble additives were each dissolved in the respective organic solvent in relative amounts in accordance with the tabulated formulations under stirring and heating to a temperature of about 70°C, which was maintained for 3 h. The resulting homogeneous vehicle solutions were then allowed to cool to ambient temperature. Subsequently the aluminum powder, glass frit and any additive non-soluble in the organic solvent were in each case added to the corresponding vehicle solution in respective relative amounts in accordance with the tabulated formulations and dispersed by stirring. Each dispersion was homogenized with a Puhler PTR 65C three roll mill until a paste was obtained that exhibited a fineness of grind of less than 15 μm upon measurement according to ASTM-D 1210 employing a stepped Hegman-type gage supplied by Shanghai Xiandai Environmental Engineering Technology Co. Ltd. having a scale range of 0-25 μm and a step width of 1.25 μm and sweeping the scraper from the deep end to the shallow end of the gage with a uniform motion. After achievement of such fineness of grind the pastes were vacuum degassed and stored for further use.

Characterization of prepared aluminum pastes

The formulations according to Table 2 are conductive A1 pastes according to the present invention, wherein the amount of thixotropic agents Hycasol R12 (Examples 3A-C) and Crayvallac MT (Examples 4A-C), respectively, was systematically increased versus a composition that contained no such thixotropic agent (Example 5). The rheological properties of these pastes were measured as described for the vehicle solutions with the only difference that the thixotropic index was calculated as the ratio of the measured viscosity at a rotational speed of 0.1 rpm to the viscosity measured at a viscosity of 1 rpm. The results in terms of viscosity, thixotropic loop and the thixotropic index $\eta_{0.1}/\eta_1$ are included in Table 2. As evidenced by Examples 3A-C and 4A-C in comparison to Example 5 the thixotropic properties of a conductive composition according to the invention can be enhanced significantly by the incorporation of an amide functional wax. The viscosity, thixotropic loop and the thixotropic index increase steadily with the amount of added Hycasol R12 or Crayvallac MT. By addition of such amide wax in an amount as low as 0.06 wt.% based on the total weight of the paste the thixotropic loop can be increased by about 50%. Simultaneously the thixotropic index can be increased from 1.6 for 0 wt.% of thixotropic agent to 2.9 or more for 0.06 wt.% of said additives. Thus conductive pastes are provided by the present invention that exhibit excellent processing properties for the preparation of well defined electrically conductive structures on a substrate for instance by screen printing, in particular having low flowability and high sag resistance with excellent ability to hold the shape when no shear stress is applied, while the viscosity can be significantly reduced by the application of shear stress.

Table 2: Composition (wt.%) and rheological properties of prepared conductive A1 pastes according the present invention (Examples 3A-C, 4A-C and 5)

| **Component** | **Example** | | | | | | |
|---|---|---|---|---|---|---|---|
| | **3A** | **3B** | **3C** | **4A** | **4B** | **4C** | **5** |
| **EC STD 45** | 0.8 | 0.8 | 0.8 | 0.8 | 0.8 | 0.8 | 0.8 |
| **DC 217** | 0.5 | 0.5 | 0.5 | 0.5 | 0.5 | 0.5 | 0.5 |
| **Span 85[1]** | 0.1 | 0.1 | 0.1 | 0.1 | 0.1 | 0.1 | 0.1 |
| **DBP[2]** | 0.1 | 0.1 | 0.1 | 0.1 | 0.1 | 0.1 | 0.1 |
| **GP 330[3]** | 0.1 | 0.1 | 0.1 | 0.1 | 0.1 | 0.1 | 0.1 |
| **BYK 333[4]** | 0.1 | 0.1 | 0.1 | 0.1 | 0.1 | 0.1 | 0.1 |
| **Hycasol R12[5]** | 0.02 | 0.04 | 0.06 | - | - | - | - |
| **Crayvallac MT[6]** | - | - | - | 0.02 | 0.04 | 0.06 | - |
| **BC** | 24.28 | 24.26 | 24.24 | 24.28 | 24.26 | 24.24 | 24.3 |
| **A1 powder KY456** | 72.0 | 72.0 | 72.0 | 72.0 | 72.0 | 72.0 | 72.0 |
| **Glass frit XY18008** | 2.0 | 2.0 | 2.0 | 2.0 | 2.0 | 2.0 | 2.0 |

(continued)

| Component | Example | | | | | | |
|---|---|---|---|---|---|---|---|
| | 3A | 3B | 3C | 4A | 4B | 4C | 5 |
| **Property** | | | | | | | |
| **Viscosity [mPa·s]** | 31,000 | 32,000 | 39,000 | 35,000 | 38,000 | 45,000 | 15,000 |
| **Thixotropic loop [Pa/s]** | 247 | 280 | 301 | 239 | 283 | 320 | 203 |
| $\eta_{0.1}/\eta_1$ | 2.3 | 2.6 | 2.9 | 2.4 | 2.8 | 3.2 | 1.6 |

[1] sorbitan trioleate, non-ionic surfactant from Sinopharm Chemical Reagent Co. Ltd.
[2] di-butyl phthalate, plasticizer from Sinopharm Chemical Reagent Co. Ltd.
[3] polypropylene glycol glycerol ether, defoamer from Hai'an Petrochemical
[4] liquid polyether modified polydimethylsiloxane, leveling agent from BYK Chemie GmbH
[5] amide modified hydrogenated castor oil from Olechemical
[6] amide modified hydrogenated castor oil from Cray Valley

The formulations according to Table 3 were prepared to investigate the effects of organopolysiloxane incorporation into conductive aluminum pastes having a vehicle with ethyl cellulose binder. Single crystalline silicon wafers with lateral dimensions of 125 x 125 $mm^2$ and a thickness of 200 μm were each coated with a loading of about 1.0 g of one of the prepared conductive pastes by using an AFA-III automatic thick film coater equipped with a stainless steel blade and a drying box. The cast films were dried in air at 230°C for 5 min yielding dried films of a thickness of 25 ± 3 μm. The dried films were subsequently sintered in air using a programmable sintering oven by raising the temperature from room temperature to 790°C within 5 s, increasing the temperature further from 790 to 802°C within 10 s, holding the temperature of 802°C for 2 s and then decreasing the temperature again to room temperature within 6 s. The obtained coatings were visually inspected for the presence of macroscopic defects in terms of surface bubbles and coarse particulates. Warping of the silicon substrate was determined by placing the coated wafer with its coated side on the surface of a plain glass body, measuring the distance between the upper end of the wafer to the bottom of the glass body with a digital micrometer and deducting the thickness of the glass body and the silicon wafer thickness. The peel adhesion of the coating to the substrate was tested on an Instron 5566 Universal Mechanical tester according to method A of ASTM D3330 by applying through three times lengthwise manual rolling with a steel roller having a mass of 1 kg a 25 mm wide, 300 mm long aluminum sticky tape of type JAL 150 from JINGTHUA TAPE to the coating along the centerline of the 125 mm wide wafer such that the remaining 175 mm protrude on one side of the wafer forming a free end, fixing the wafer and the free end of the tape in coaxial clamps of the tester and subsequent 180 degree peeling using a tensile rate of 500 mm/min and recording the corresponding force. The adhesion force reported in Table 3 is expressed in terms of the average recorded force value required for peeling off normalized to the width of the sticky tape. The sheet resistance of the coating was further measured by a DMR-1C resistance meter from DM, Nanjing, Jiangsu in four point probe arrangement. The results of these characterization methods are summarized in Table 3 along with the rheological properties of the pastes that were measured as described for the formulations of Table 2.

The results in Table 3 indicate that with systematic increase of the amount of DC 217 added to the paste (Examples 6A-6D) at a constant total binder load (ethyl cellulose plus organopolysiloxane) the adhesion force of a sintered electrode prepared from the conductive pastes to a silicon substrate steadily increases from a reference value of 0.56 N/mm for a paste containing only ethyl cellulose as binder, but no solid organopolysiloxane resin (Comp. Ex. 9) to 1.12 N/mm for 1 wt.% of DC 217 in the initial paste. Moreover the warping of the substrate was reduced to less than 1 mm when DC 217 was incorporated into the initial paste in an amount of 0.3 wt.% or more versus a substrate warp of 1.5 mm when no such solid organopolysiloxane resin was used. Furthermore the sintered electrodes obtained in case of Examples 6A-6D were uniform and free of macroscopic defects such as surface bubbles and coarse particulates in contrast to the coatings obtained in case of Comparative Examples 9 and 10. The paste of Comparative example 10 containing DC 217, but no ethyl cellulose binder moreover showed lower viscosity and degraded thixotropic properties versus the pastes of Example 6A-6D. These findings indicate that the use of a vehicle that comprises a combination of ethyl cellulose with a solid organopolysiloxane resin dissolved in a mutual organic solvent provides an advantageous, more balanced property profile versus the individual use of such binders in conductive metal pastes. Due to the excellent compatibility of both binders and their synergism pastes of excellent dispersion stability and rheological properties are obtainable, from which well-defined electrically conductive structures free of macroscopic defects can be prepared on a silicone substrate exhibiting significantly enhanced adhesion to the substrate and inducing less substrate warping.

The observed increase of the sheet resistance caused by introducing the organopolysiloxane resin into the paste (Ex. 6A-6D versus Comp. Ex. 9), which is probably related to silica residuals formed by sintering, can easily be more than compensated by the addition of a conductive agent such as graphite in an amount as low as 0.05 wt.% based on the total weight of the paste (Ex. 6E), if required by the targeted application.

The use of a silicone oil (Comp. Ex. 7) instead of a solid organopolysiloxane resin in combination with the ethyl cellulose binder does not provide analogous benefits, but rather degrades the thixotropic properties and the viscosity significantly impairing the processability, in particular the screen printability, of the conductive formulation. The dispersion of Comparative Example 7 was further not stable showing settling after storage at ambient temperature for 48 h, whereas the pastes according to the invention remained uniform and stable under these conditions. Moreover the adhesion force of the corresponding sintered coating to the silicon substrate was significantly lower and the sheet resistance with 108.6 mΩ more than double the value of 52.8 mΩ for a the coating of an analogous paste wherein the same amount of a solid organopolysiloxane resin was incorporated (Ex. 6C).

The comparison of Comparative Example 8 with Example 6D shows moreover that the peel adhesion force is reduced by a factor of about 4 and the sheet resistance increases dramatically from 85.7 mΩ to more than 700 mΩ if the glass frit is omitted from the metal paste. This evidences that the glass frit is an essential component of the conductive compositions according to the present invention and may not be replaced by an organopolysiloxane binder as proposed by US 2011/0217809 A1 without severely impairing the adhesion to the silicon substrate and the ohmic contact between the metal phase and the substrate achieved by sintering.

Table 3: Composition (wt.%) and rheological properties of prepared conductive A1 pastes (Examples 6A-E, Comparative Examples 7-10) and properties of sintered coatings prepared therefrom on silicon substrates

| **Component** | **Example** | | | | | | | | |
|---|---|---|---|---|---|---|---|---|---|
| | **6A** | **6B** | **6C** | **6D** | **6E** | **7 (Comp. Ex.)** | **8 (Comp. Ex.)** | **9 (Comp. Ex.)** | **10 (Comp. Ex.)** |
| **EC STD 45** | 1 | 0.8 | 0.5 | 0.3 | 0.3 | 0.5 | 0.3 | 1.3 | - |
| **DC 217** | 0.3 | 0.5 | 0.8 | 1 | 1 | - | 1 | - | 1.3 |
| **201 methyl silicone oil** | - | - | - | - | - | 0.8 | - | - | - |
| **Span 85**[1] | 0.1 | 0.1 | 0.1 | 0.1 | 0.1 | 0.1 | 0.1 | 0.1 | 0.1 |
| **DBP**[2] | 0.1 | 0.1 | 0.1 | 0.1 | 0.1 | 0.1 | 0.1 | 0.1 | 0.1 |
| **GP 330**[3] | 0.1 | 0.1 | 0.1 | 0.1 | 0.1 | 0.1 | 0.1 | 0.1 | 0.1 |
| **BYK 333**[4] | 0.1 | 0.1 | 0.1 | 0.1 | 0.1 | 0.1 | 0.1 | 0.1 | 0.1 |
| **Hycasol R12**[5] | 0.02 | 0.02 | 0.02 | 0.02 | 0.02 | 0.02 | 0.02 | 0.02 | 0.02 |
| **SFG6**[6] | - | - | - | - | 0.05 | - | - | - | 0.05 |
| **BC** | 24.28 | 24.28 | 24.28 | 24.28 | 24.23 | 24.28 | 26.28 | 24.28 | 24.23 |
| **Al powder KY456** | 72.0 | 72.0 | 72.0 | 72.0 | 72.0 | 72.0 | 72.0 | 72.0 | 72.0 |
| **Glass frit XY18008** | 2.0 | 2.0 | 2.0 | 2.0 | 2.0 | 2.0 | - | 2.0 | 2.0 |
| **Paste property** | | | | | | | | | |
| **Viscosity [mPa·s]** | 36,000 | 31,000 | 30,000 | 28,000 | 30,000 | 13,000 | 19,000 | 37,000 | 20,000 |
| **Thixotropic loop [Pa/s]** | 283 | 247 | 232 | 218 | 213 | 160 | 211 | 288 | 198 |
| $\eta_{0.1}/\eta_1$ | 2.6 | 2.3 | 2.3 | 2.0 | 2.2 | 1.5 | 1.8 | 2.7 | 1.9 |
| **Coating property** | | | | | | | | | |

(continued)

| Component | Example | | | | | | | | |
|---|---|---|---|---|---|---|---|---|---|
| | **6A** | **6B** | **6C** | **6D** | **6E** | **7 (Comp. Ex.)** | **8 (Comp. Ex.)** | **9 (Comp. Ex.)** | **10 (Comp. Ex.)** |
| **Surface bubbles?** | no | no | no | no | no | yes | no | yes | no |
| **Coarse particulates?** | no | no | no | no | no | no | yes | no | yes |
| **Substrate warp [mm]** | 0.8 | 0.9 | 0.7 | 0.8 | 0.9 | 0.8 | 0.6 | 1.5 | 0.7 |
| **Adhesion force [N/mm]** | 0.71 | 0.75 | 0.89 | 1.12 | 1.08 | 0.50 | 0.31 | 0.56 | 1.11 |
| **Sheet resistance [mΩ]** | 30.3 | 42.5 | 52.8 | 85.7 | 12.3 | 108.6 | 726.3 | 22.4 | 112.4 |

[1] sorbitan trioleate, non-ionic surfactant from Sinopharm Chemical Reagent Co. Ltd.
[2] di-butyl phthalate, plasticizer from Sinopharm Chemical Reagent Co. Ltd.
[3] polypropylene glycol glycerol ether, defoamer from Hai'an Petrochemical
[4] liquid polyether modified polydimethylsiloxane, leveling agent from BYK Chemie GmbH
[5] amide modified hydrogenated castor oil from Olechemical
[6] Graphite powder, conductive agent from TIMCAL Graphite & Carbon Ltd.

In Table 4 the performance of another conductive paste according to the invention (Example 11) with respect to the preparation of an aluminum electrode for a silicon solar cell is compared to two commercially available conductive aluminum pastes (Comparative Examples 12 and 13) used for solar cell applications. The preparation of coatings on silicon wafers from these pastes as well as the evaluation and testing of the pastes and coatings were carried out as described above for the formulations of Table 3. The paste according to the present invention exhibits more pronounced thixotropic properties compared to the commercial pastes yielding better processing characteristics such as a better screen printability. The sintered electrode prepared from the formulation of Example 11 shows similar low substrate warping as upon use of the commercial pastes and no macroscopic defects in terms of bubbles or coarse particulates, whereas the coating made from the commercial aluminum paste ZL-120 X (Comp. Ex. 12) had some surface bubbles. Furthermore the sheet resistance of the electrode prepared from the paste according to the present invention was significantly lower than for the electrode made from ZL-120 X and the peel adhesion force is almost twice as high as for the coating obtained from the commercial paste Solus 6220 (Comp. Ex. 13). In total conductive pastes according to the invention therefore show competitive performance to conventional commercially available metal pastes for solar applications and may thus be advantageously used for the fabrication of silicon solar cells with enhanced cell conversion efficiency.

Table 4: Composition (wt.%) and rheological properties of conductive A1 paste according to the present invention (Examples 11) versus commercially available A1 pastes ZL-120X (Comp. Ex. 12) and Solus 6220 (Comp. Ex. 13) and comparison of the properties of sintered electrodes prepared from these pastes on silicon substrates

| **Example 11** | | **Comparative Example 12** | **Comparative Example 13** |
|---|---|---|---|
| **Component** | **Wt.%** | Aluminum paste ZL-120 X from Zhuoli Electronic Materials Co. Ltd. | Aluminum paste Solus 6220 from Carla Gilmastin EM |
| EC STD 10 | 0.55 | | |
| EC STD 100 | 0.05 | | |
| DC 217 | 0.8 | | |
| Span 85[1] | 0.1 | | |
| DBP[2] | 0.1 | | |
| GP 330[3] | 0.15 | | |
| BYK 333[4] | 0.1 | | |
| Hycasol R12[5] | 0.15 | | |
| SFG6[6] | 0.05 | | |
| BC | 21.98 | | |
| A1 powder KY456 | 73.97 | | |
| Glass frit XY18008 | 2.0 | | |
| **Paste property** | | | |
| Viscosity [mPa·s] | 58,000 | 39,000 | 30,000 |
| Thixotropic loop [Pa/s] | 485 | 360 | 200 |
| $\eta_{0.1}/\eta_1$ | 3.4 | 2.9 | 2.0 |
| **Coating property** | | | |
| Surface bubbles? | no | yes | no |
| Coarse particulates? | no | no | no |
| Substrate warp [mm] | 0.8 | 0.8 | 0.6 |
| Adhesion force [N/mm] | 1.23 | 1.30 | 0.65 |
| Sheet resistance [mΩ] | 11 | 16 | 10 |

[1] sorbitan trioleate, non-ionic surfactant from Sinopharm Chemical Reagent Co. Ltd.
[2] di-butyl phthalate, plasticizer from Sinopharm Chemical Reagent Co. Ltd.
[3] polypropylene glycol glycerol ether, defoamer from Hai'an Petrochemical
[4] liquid polyether modified polydimethylsiloxane, leveling agent from BYK Chemie GmbH
[5] amide modified hydrogenated castor oil from Olechemical
[6] Graphite powder, conductive agent from TIMCAL Graphite & Carbon Ltd.

## Claims

**1.** A conductive composition comprising

a. a plurality of metal particles,
b. a plurality of glass particles,
c. a vehicle comprising at least one cellulose derivative and at least one solid organopolysiloxane resin dissolved in a mutual organic solvent wherein the at least one solid organopolysiloxane resin has a composition of the formula

$$[R^1R^2R^3SiO_{0.5}]_a\ [R^4R^5SiO]_b\ [R^6SiO_{1.5}]_c\ [SiO_2]_d$$

wherein the substituents $R^1$, $R^2$, $R^3$, $R^4$, $R^5$ and $R^6$ each independently represent a hydrocarbon group or a functional group selected from a hydroxyl, an acyloxy group or an alkoxy group, and may be the same or different from each other with respect to each individual silicon atom, and

$$0 \le a \le 0.4,$$

$$0.01 \le b \le 0.99,$$

$$0.01 \le c \le 0.99,$$

$$0 \le d \le 0.3,$$

under the proviso that at least one hydrocarbon group and at least one functional group are present and a+b+c+d = 1, preferably (b+c) being in a range of 0.7 to 1.

**2.** The conductive composition of claim 1, wherein the metal particles are selected from particles made of aluminum, silver, copper, nickel, platinum, palladium, gold or alloys of any of the foregoing, or mixtures thereof, and/or wherein the glass particles comprise oxides selected from $SiO_2$, $B_2O_3$, $Al_2O_3$, $Bi_2O_3$, MgO, $Sb_2O_3$, PbO, CaO, BaO, ZnO, $Na_2O$, $Li_2O$, $K_2O$, $ZrO_2$, $TiO_2$, $IrO_2$, $SnO_2$ and combinations thereof.

**3.** The conductive composition of claim 1 or 2, wherein the at least one cellulose derivative is a cellulose ester and/or a cellulose ether, preferably being ethyl cellulose.

**4.** The conductive composition of any one of the preceding claims, wherein the at least one hydrocarbon group is selected from an alkyl, cycloalkyl, aryl or aralkyl group having 1 to 12 carbon atoms or a mixture of any of the foregoing, preferably being selected from an alkyl group having 1 to 4 carbon atoms and/or a phenyl group, and/or wherein the one or more functional groups are hydroxyl groups.

**5.** The conductive composition according to any one of the preceding claims, wherein the at least one solid organopolysiloxane resin is hydroxy-functional, preferably comprising silicon-bound hydroxyl groups in an amount of 0.1 to 15 wt.% based on the total weight of the organopolysiloxane resin.

**6.** The conductive composition of any one of the preceding claims, wherein the at least one solid organopolysiloxane resin has a branched molecular structure, preferably a three-dimensional cross-linked network structure.

**7.** The conductive composition according to any one of the preceding claims, wherein the at least one solid organopolysiloxane resin has a weight average molecular weight as measured by gel permeation chromatography using polystyrene standards in the range of 1,000 to 300,000 g/mol.

**8.** The conductive composition of any of the preceding claims, wherein the organic solvent is an organic solvent having a boiling point in the range from 70 to 250°C, preferably being selected from terpineol, butyl carbitol, ethylene glycol monobutyl ether acetate, propylene phenoxetol, Texanol or a mixture of any of the foregoing.

**9.** The conductive composition of any one of the preceding claims comprising further one or more additional polymeric binders and/or one or more additives different from the metal particles, glass particles, cellulose derivative, solid organopolysiloxane resin and organic solvent, the one or more additives being preferably selected from a plasticizer, a surfactant, a coupling agent, a defoaming agent, a leveling agent, a dispersing agent, a conductive agent and a thixotropic agent.

**10.** The conductive composition of any one of the preceding claims comprising further at least one amide-functional organic oil or wax, preferably an amide modified hydrogenated castor oil, as thixotropic agent and/or at least one

carbonaceous conductive agent, preferably graphite, as a conductive agent.

**11.** The conductive composition of any one of the preceding claims comprising

a. 60 to 90 wt.% metal particles, and/or
b. 0.5 to 5 wt.% glass particles, and/or
c. 0.1 to 5 wt.% of the at least one cellulose derivative, and/or
d. 0.1 to 5 wt.% of the at least one solid polysiloxane resin, and/or
e. 15 to 30 wt.% of the organic solvent, and/or
f. 0 to 3 wt.% of additional polymeric binder, if any, and/or
g. 0 to 2 wt.% of one or more additives, if any,

each based on the total weight of the conductive composition.

**12.** The conductive composition according to any one of the preceding claims being a paste and/or having a viscosity in the range of 5,000 to 200,000 mPa·s as measured with a Brookfield RV DV-II+ Pro instrument at a temperature of 23°C using a #51 spindle and a rotational speed of 1 rpm.

**13.** A method for preparing one or more electrically conductive structures on a substrate comprising

a. Applying a conductive composition according to any one of claims 1 to 12 to at least a part of a surface of the substrate,
b. Drying the applied conductive composition at least partially, and then
c. Sintering at a temperature above 600°C.

**14.** A semiconductor solar cell comprising one or more electrodes prepared from the conductive composition of any one of claims 1 to 12.

## Patentansprüche

**1.** Leitfähige Zusammensetzung enthaltend

a. eine Vielzahl von Metallpartikeln,
b. eine Vielzahl von Glaspartikeln,
c. ein Träger, der zumindest ein Zellulosederivat und zumindest ein festes Organopolysiloxanharz enthält, welche in einem gemeinsamen organischen Lösemittel gelöst sind, wobei das zumindest eine Organopoysiloxanharz eine Zusammensetzung mit der Formel

$$[R^1R^2R^3SiO_{0,5}]_a\ [R^4R^5SiO]_b\ [R^6SiO_{1,5}]_c\ [SiO_2]_d$$

aufweist, wobei die Substituenten $R^1$, $R^2$, $R^3$, $R^4$, $R^5$ und $R^6$ jeweils unabhängig voneinander eine Kohlenwasserstoffgruppe oder eine funktionelle Gruppe, ausgewählt aus einer Hydroxyl-, einer Acyloxy-Gruppe oder einer Alkoxy-Gruppe darstellen, und die Substituenten können hinsichtlich jedes einzelnen Siliciumatom gleich oder verschieden sein, und

$$0 \leq a \leq 0,4$$

$$0,01 \leq b \leq 0,99,$$

$$0,01 \leq c \leq 0,99,$$

$$0 \leq d \leq 0,3,$$

unter der Bedingung, dass zumindest eine Kohlenwasserstoffgruppe und zumindest eine funktionelle Gruppe anwesend sind und a+b+c+d = 1, bevorzugt ist (b+c) im Bereich von 0,7 bis 1.

2. Leitfähige Zusammensetzung nach Anspruch 1, wobei die Metallpartikel ausgewählt sind aus Partikeln, welche aus Aluminium, Silber, Kupfer, Nickel, Platin, Palladium, Gold oder Legierungen aus einem der vorgenannten Metalle oder deren Mischung, hergestellt sind, und/oder wobei die Glaspartikel Oxide enthalten und ausgewählt sind aus $SiO_2$, $B_2O_3$, $Al_2O_3$, $Bi_2O_3$, MgO, $Sb_2O_3$, PbO, CaO, BaO, ZnO, $Na_2O$, $Li_2O$, $K_2O$, $ZrO_2$, $TiO_2$, $IrO_2$, $SnO_2$ und deren Kombinationen.

3. Leitfähige Zusammensetzung nach Anspruch 1 oder 2, wobei das zumindest eine Zellulosederivat ein Zelluloseester und/oder ein Zelluloseether, bevorzugt eine Ethylzellulose ist.

4. Leitfähige Zusammensetzung nach einem der vorgenannten Ansprüche, wobei die zumindest eine Kohlenwasserstoffgruppe ausgewählt ist aus einem Alkyl, einem Cycloalkyl, einer Aryl- oder Aralkylgruppe, welche 1 bis 12 Kohlenstoffatome aufweist oder eine Mischung von einem der vorgenannten Kohlenwasserstoffgruppen, bevorzugt ausgewählt aus einer Alkylgruppe, welche 1 bis 4 Kohlenstoffatome aufweist und/oder einer Phenylgruppe, und/oder wobei die eine oder mehrere funktionelle Gruppen Hydroxylgruppen sind.

5. Leitfähige Zusammensetzung nach einem der vorgenannten Ansprüche, wobei das zumindest eine feste Organopolysiloxanharz hydroxyfunktionalisiert ist, bevorzugt sind die siliciumgebundene Hydroxylgruppen in einer Menge von 0,1 bis 15 Gewichtsprozent, basierend auf dem Gesamtgewicht des Organopolysiloxanharzes, vorhanden.

6. Leitfähige Zusammensetzung nach einem der vorgenannten Ansprüche, wobei das zumindest eine feste Organopolysiloxanharz eine verzweigte Molekularstruktur, bevorzugt eine dreidimensionale vernetzte Netzwerkstruktur, aufweist.

7. Leitfähige Zusammensetzung nach einem der vorgenannten Ansprüche, wobei das zumindest eine feste Organopolysiloxanharz ein mittleres Molekulargewicht in einem Bereich von 1.000 bis 300.000 g/mol, gemessen mit Hilfe von Gelpermeationschromatographie mit Polystyrol als Standart, aufweist.

8. Leitfähige Zusammensetzung nach einem der vorgenannten Ansprüche, wobei das organische Lösungsmittel ein organisches Lösungsmittel ist, welches einen Siedepunkt in dem Bereich von 70 bis 250 °C aufweist, bevorzugt ist das organische Lösungsmittel ausgewählt aus Terpineol, Butyl, Butylcarbitol, Ethylenglykol, Monobutyletheracetat, Propylenphenoxetol, Texanol oder Mischungen aus den vorgenannten Lösungsmitteln.

9. Leitfähige Zusammensetzung nach einem der vorgenannten Ansprüche, welche ferner ein oder mehrere weitere polymere Binder und/oder ein oder mehrere Additive, welche unterschiedlich von den Metallpartikeln, Glaspartikeln, Zellulosederivaten, festen Organopolysiloxanharzen und organischen Lösemitteln sind enthalten, wobei die einen oder mehrere Additive bevorzugt ausgewählt sind aus einem Weichmacher, einem Tensid, einem Kupplungsmittel, einem Entschäumungsmittel, einem Verlaufmittel, einem Dispergiermittel, einem leitfähigen Mittel und einem thixotropen Mittel.

10. Leitfähige Zusammensetzung nach einem der vorgenannten Ansprüche, welche ferner zumindest ein amidfunktionelles organisches Öl oder Wachs, bevorzugt ein amidmodifiziertes hydriertes Rizinusöl, als ein thixotropes Mittel und/oder zumindest ein kohlenstoffhaltiges leitfähiges Mittel, bevorzugt Graphit, als ein leitfähiges Mittel, enthält.

11. Leitfähige Zusammensetzung nach einem der vorgenannten Ansprüche, enthaltend

a. 60 bis 90 Gew.-% Metallpartikel, und/oder
b. 0,5 bis 5 Gew.-% Glaspartikel, und/oder
c. 0,1 bis 5 Gew.-% von dem zumindest einen Zellulosederivat, und/oder
d. 0,1 bis 5 Gew.-% von dem zumindest einen festen Polysiloxanharz, und/oder
e. 15 bis 30 Gew.-% von dem organischen Lösungsmittel, und/oder
f. 0 bis 3 Gew.-% von weiteren polymerischen Bindern, wenn vorhanden, und/oder
g. 0 bis 2 Gew.-% von einem oder mehreren Additiven, wenn vorhanden, wobei
die jeweiligen Gewichtsangaben auf dem Gesamtgewicht der leitfähigen Zusammensetzung basieren.

12. Leitfähige Zusammensetzung nach einem der vorgenannten Ansprüche, wobei die leitfähige Zusammensetzung

eine Paste ist und/oder eine Viskosität in dem Bereich von 5.000 zu 200.000 mPa·s, gemessen mit einem Brookfield RV DV-II+ Pro Instrument bei einer Temperatur von 23°C mit einer #51 Spindel und einer Rotationsgeschwindigkeit von 1 rpm, aufweist.

**13.** Verfahren zur Herstellung von einer oder mehreren elektrisch leitfähigen Strukturen auf einem Substrat umfassend

a. Auftragen der leitfähigen Zusammensetzung nach einem der Ansprüche 1 bis 12 auf zumindest einem Teil der Oberfläche des Substrats,
b. zumindest teilweises Trocknen der aufgetragenen leitfähigen Zusammensetzung, und dann
c. Sintern bei einer Temperatur oberhalb von 600°C.

**14.** Halbleitende Solarzelle, welche ein oder mehrere Elektronen enthält, die aus einer der leitfähigen Zusammensetzungen nach einem der Ansprüche 1 bis 12, hergestellt ist.

**Revendications**

**1.** Une composition conductrice comprenant

a. une pluralité de particules de métal,
b. une pluralité de particules de verre,
c. un véhicule comprenant au moins un dérivé de la cellulose et au moins une résine organopolysiloxane solide dissous dans un solvant organique mutuel, l'au moins une résine organopolysiloxane solide ayant une composition de la formule

$$[R^1R^2R^3SiO_{0,5}]_a\ [R^4R^5SiO]_b\ [R^6SiO_{1,5}]_c\ [SiO_2]_d$$

dans laquelle les substituants $R^1$, $R^2$, $R^3$, $R^4$, $R^5$ et $R^6$ représentent chacun indépendamment un groupe hydrocarboné ou un groupe fonctionnel sélectionné parmi un hydroxyle, un groupe acyloxy ou un groupe alcoxy, et peuvent être identiques ou différents les uns des autres par rapport à chaque atome de silicium individuel, et

$$0 \le a \le 0{,}4,$$

$$0{,}01 \le b \le 0{,}99,$$

$$0{,}01 \le c \le 0{,}99,$$

$$0 \le d \le 0{,}3,$$

à la condition qu'au moins un groupe hydrocarboné et au moins un groupe fonctionnel soient présents et que a + b + c + d = 1, préférablement (b + c) étant compris dans un intervalle de 0,7 à 1.

**2.** La composition conductrice de la revendication 1, dans laquelle les particules de métal sont sélectionnées parmi des particules faites d'aluminium, d'argent, de cuivre, de nickel, de platine, de palladium, d'or ou d'alliages de n'importe lesquels des métaux susdits, ou de mélanges de ceux-ci, et/ou dans laquelle les particules de verre comprennent des oxydes sélectionnés parmi $SiO_2$, $B_2O_3$, $Al_2O_3$, $Bi_2O_3$, MgO, $Sb_2O_3$, PbO, CaO, BaO, ZnO, $Na_2O$, $Li_2O$, $K_2O$, $ZrO_2$, $TiO_2$, $IrO_2$, $SnO_2$ et des combinaisons de ceux-ci.

**3.** La composition conductrice de la revendication 1 ou de la revendication 2, dans laquelle l'au moins un dérivé de la cellulose est un ester de cellulose et/ou un éther de cellulose, lequel est préférablement de l'éthylcellulose.

**4.** La composition conductrice de l'une quelconque des revendications précédentes, dans laquelle l'au moins un groupe hydrocarboné est sélectionné parmi un groupe alkyle, cycloalkyle, aryle ou aralkyle ayant 1 à 12 atomes de carbone

ou un mélange de n'importe lesquels des groupes susdits, lequel est préférablement sélectionné parmi un groupe alkyle ayant 1 à 4 atomes de carbone et/ou un groupe phényle, et/ou dans laquelle les un ou plusieurs groupes fonctionnels sont des groupes hydroxyle.

**5.** La composition conductrice selon l'une quelconque des revendications précédentes, dans laquelle l'au moins une résine organopolysiloxane solide est à fonction hydroxy, laquelle comprend préférablement des groupes hydroxyle liés au silicium dans une quantité de 0,1 à 15 % en poids rapporté au poids total de la résine organopolysiloxane.

**6.** La composition conductrice de l'une quelconque des revendications précédentes, dans laquelle l'au moins une résine organopolysiloxane solide a une structure moléculaire ramifiée, préférablement une structure de réseau réticulé tridimensionnelle.

**7.** La composition conductrice selon l'une quelconque des revendications précédentes, dans laquelle l'au moins une résine organopolysiloxane solide a une masse moléculaire moyenne en poids telle que mesurée par chromatographie par perméation de gel en utilisant des étalons de polystyrène comprise dans l'intervalle de 1 000 à 300 000 g/mol.

**8.** La composition conductrice de n'importe lesquelles des revendications précédentes, dans laquelle le solvant organique est un solvant organique ayant un point d'ébullition compris dans l'intervalle allant de 70 à 250 °C, lequel est préférablement sélectionné parmi le terpinéol, le butyl carbitol, l'acétate d'éther monobutylique d'éthylène glycol, le propylène phénoxétol, le Téxanol ou un mélange de n'importe lesquels des solvants susdits.

**9.** La composition conductrice de l'une quelconque des revendications précédentes comprenant en sus un ou plusieurs liants polymères supplémentaires et/ou un ou plusieurs additifs différents des particules de métal, des particules de verre, du dérivé de la cellulose, de la résine organopolysiloxane solide et du solvant organique, ces un ou plusieurs additifs étant préférablement sélectionnés parmi un plastifiant, un tensioactif, un agent de couplage, un agent antimousse, un agent de lissage, un agent dispersant, un agent conducteur et un agent thixotropique.

**10.** La composition conductrice de l'une quelconque des revendications précédentes comprenant en sus au moins une cire ou huile organique à fonction amide, préférablement une huile de ricin hydrogénée modifiée par amide, comme agent thixotropique et/ou au moins un agent conducteur carboné, préférablement du graphite, comme agent conducteur.

**11.** La composition conductrice de l'une quelconque des revendications précédentes comprenant

a. 60 à 90 % en poids de particules de métal, et/ou
b. 0,5 à 5 % en poids de particules de verre, et/ou
c. 0,1 à 5 % en poids de l'au moins un dérivé de la cellulose, et/ou
d. 0,1 à 5 % en poids de l'au moins une résine polysiloxane solide, et/ou
e. 15 à 30 % en poids du solvant organique, et/ou
f. 0 à 3 % en poids de liant polymère supplémentaire, s'il y en a, et/ou
g. 0 à 2 % en poids d'un ou de plusieurs additifs, s'il y en a,

chacun rapporté au poids total de la composition conductrice.

**12.** La composition conductrice selon l'une quelconque des revendications précédentes, laquelle est une pâte et/ou a une viscosité comprise dans l'intervalle de 5 000 à 200 000 mPa•s telle que mesurée avec un instrument Brookfield RV DV-II+ Pro à une température de 23 °C en utilisant un mobile #51 et une vitesse de rotation de 1 tr/min.

**13.** Une méthode pour préparer une ou plusieurs structures électroconductrices sur un substrat comprenant

a. l'application d'une composition conductrice selon l'une quelconque des revendications 1 à 12 sur au moins une partie d'une surface du substrat,
b. le séchage au moins partiel de la composition conductrice appliquée, puis
c. le frittage à une température au-dessus de 600 °C.

**14.** Une cellule solaire à semiconducteur comprenant une ou plusieurs électrodes préparées à partir de la composition conductrice de l'une quelconque des revendications 1 à 12.

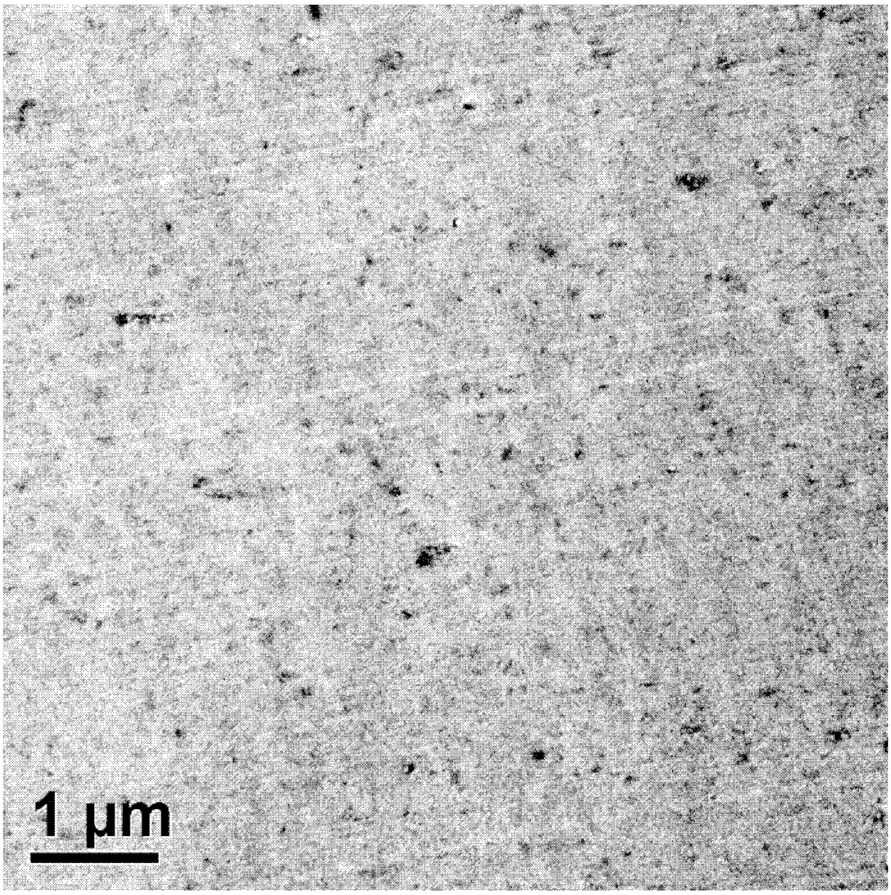


Fig. 1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20100186823 A1
- US 20110014743 A
- US 20080302411 A1
- US 20110217809 A1
- CN 101555394 A
- CN 101710497 A
- US 20090120490 A1


### Non-patent literature cited in the description


- *Cellulose Communication,* 1999, vol. 6, 73-79
- *Chirality,* 2000, vol. 12 (9), 670-674
- Comprehensive cellulose chemistry. Wiley-VCH, 2001, vol. 2
- Ullmanns Encyklopädie der Technischen Chemie. Verlag Chemie, vol. 9, 192-212
- ULLMANNS ENCYKLOPÄDIE DER TECHNISCHEN CHEMIE. 227-246
- ULLMANNS ENCYKLOPÄDIE DER TECHNISCHEN CHEMIE. vol. 17, 343-354
- **G.B. SHAH.** *eXPRESS Polymer Letters,* 2008, vol. 2 (11), 830-831
- Ullmanns Encyklopädie der technischen Chemie. Verlag Chemie, vol. 21, 511-541
- **G. ENGELHARDT et al.** *Journal of Organometallic Chemistry,* 1974, vol. 54, 115-122
- **C. B. WU et al.** *High Performance Polymers,* 2010, vol. 22, 959-973
- **HUANG et al.** *Journal of Applied Polymer Science,* 1998, vol. 70, 1753-1757
- **D. MASSIOT et al.** *Magn. Reson. Chem.,* 2002, vol. 40, 70-76